(19) Europäisches Patentamt
European Patent Office
Office européen des brevets

(11) **EP 2 159 914 A1**

(12) **EUROPEAN PATENT APPLICATION**

(43) Date of publication:
**03.03.2010 Bulletin 2010/09**

(51) Int Cl.:
*H03F 1/32* (2006.01)

(21) Application number: **08275046.4**

(22) Date of filing: **27.08.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **ROKE MANOR RESEARCH LIMITED Romsey,**
**Hampshire SO51 0ZN (GB)**

(72) Inventors:
• **Smith, Christopher Nigel**
  **Romsey, Hampshire SO51 7RJ (GB)**
• **Johnson, David Antony**
  **Romsey, Hampshire SO51 5AP (GB)**

(74) Representative: **Payne, Janice Julia**
  **Siemens AG**
  **Postfach 22 16 34**
  **80506 München (DE)**

(54) **Linearisation device and method**

(57)     A linearisation device comprises a device input and a digital baseband stage. The digital baseband stage comprises an error circuit, wherein the error circuit comprises a digital representation of a component to be linearised; a digital delay, a summer and an error circuit output. A signal received at the device input is input to the digital representation and the time delay; wherein respective outputs of the digital representation and the time delay are subtracted in the summer to generate an error signal; and wherein the error signal is output from the error circuit output.

FIG 4

EP 2 159 914 A1

**Description**

This invention relates to a linearization device and method, in particular for use with radio frequency power amplifiers.

Multi-carrier RF power amplifiers for use in cellular basestation transmitters usually require some form of linearization in order to meet spectral mask and spurious emission regulations. The most stringent requirement is currently Global System for Mobile communication (GSM), where the spectral mask is defined down to -80dBc, although the invention is also applicable to other radio standards, or non-RF devices.

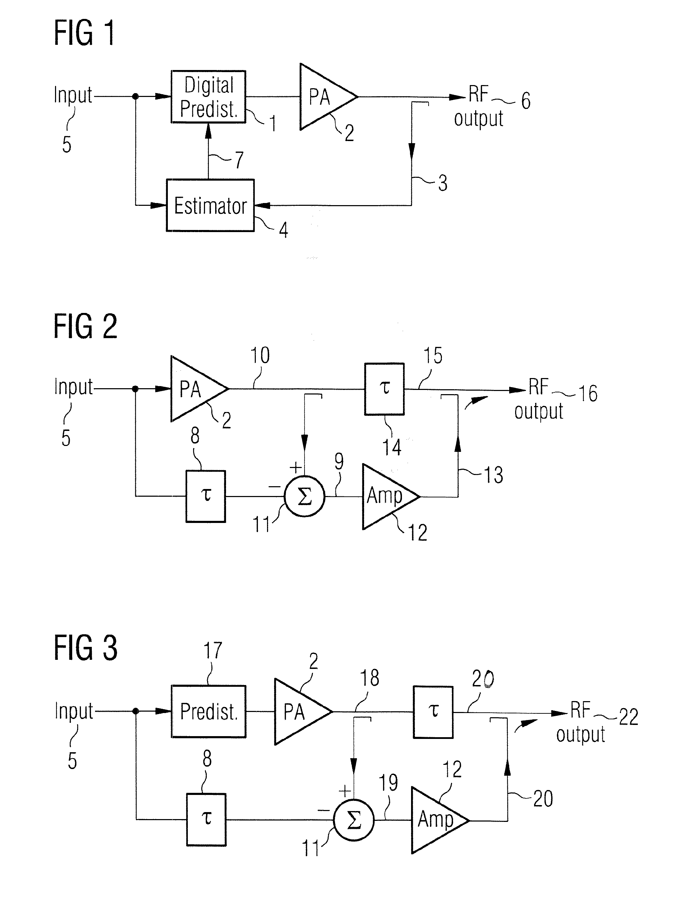

A popular form of linearization is digital predistortion, as shown in Fig.1. A digital predistorter 1 provides a compensating non-linearity having a characteristic which is chosen to cancel out the curve of the input/output characteristic, placed in a circuit before a power amplifier (PA) 2 to be linearised. Feedback 3 from the PA radio frequency (RF) output 6 is combined in an estimator 4 with an input signal 5. To take into account variations in the amplifier due to temperature, signal, supply voltage and age, the coefficients of the predistorter are periodically adapted by an adaptation output 7 resulting from comparing the overall input 5 and feedback 3 from the RF output 6 in the estimator 4, such that the residual error is minimised. However, a real power amplifier is not memoryless, so the output is not only dependent upon instantaneous input signals, but also earlier ones. Thus, in practice, the spectral mask achievable using this technique is limited to around -60 to -70dBc, particularly when the distortion produced by the power amplifier (PA) includes these memory effects.

An alternative linearization scheme is feedforward, as shown in Fig.2. In Fig.2, the input 5 is split between the PA 2 and a time delay 8. An error signal 9, generated from the delayed input signal and an output 10 of the PA 2 which are combined in a summer 11, is passed through an error amplifier 12 and the amplified error signal 13 is combined with a time delayed 14 output 15 of the PA to produce an RF signal output 16. In this mainly analogue technique, the amplifier input signal 5 and output signal 10 are subtracted to generate the error (or distortion residue) signal 9. This error is then amplified in a second amplifier 12 up to the required power level, and re-inserted at the main amplifier output 15, in anti-phase. If implemented optimally, the final output distortion level is limited only by the linearity of the error amplifier.

In practice, the delay elements 8, 14 shown in Fig.2 will not precisely match the gain, phase and delay characteristics of the amplifiers 12, 2, as the delays vary with frequency and with distortion in the error amplifier, leading to imperfect error generation and cancellation. As a result of this, it is not unknown for the error amplifier 12 to be almost as large as the main amplifier 2, leading to very poor overall efficiency.

A common improvement to the feedforward technique, is to combine it with digital predistortion of the main amplifier, as shown in Fig.3. In Fig. 3, a pre-distorter 17 is inserted in front of the PA 2. The distorted PA output 18 is combined in the summer 10 with the input signal 5, which has passed through the time delay 8, to produce an error signal 19, then amplified 12 and the amplified error signal 20 is combined with a time delayed distorted PA output 21 to form an RF output 22. The benefit of the predistorter is that the residual error signal is reduced, thus minimising the power requirements of the error amplifier. However, the insertion loss of the final output delay element remains.

In accordance with a first aspect of the present invention, a linearisation device comprises a device input and a digital baseband stage; the digital baseband stage comprising an error circuit, wherein the error circuit comprises a digital representation of a component to be linearised; a digital delay, a summer and an error circuit output; wherein a signal received at the device input is input to the digital representation and the time delay; wherein respective outputs of the digital representation and the time delay are subtracted in the summer to generate an error signal; and wherein the error signal is output from the error circuit output.

The present invention provides linearization of a component using a digital feedforward technique.

Preferably, the baseband stage further comprises a delay matching circuit; and a delay matching circuit output.

Preferably, the delay matching circuit and the digital representation of the component are implemented in a field programmable gate array.

Preferably, the delay matching circuit and the digital representation further comprise digital predistorters.

Preferably, the delay matching circuit further comprises an equaliser to correct for variation in the frequency response of the component across the signal frequency band.

Preferably, the baseband stage further comprises a digital adaptation circuit.

Preferably, the adaptation circuit comprises a digital signal processor.

Preferably, the component is an analogue component.

Preferably, the component is an RF amplifier.

In accordance with a second aspect of the present invention, a linearised power amplifier circuit comprises a device according to the first aspect; an intermediate frequency stage; and a radio frequency stage.

Preferably, the IF stage comprises signal converters to convert between digital and analogue signals and frequency converters to convert between IF and RF signals.

Preferably, the RF stage comprises the RF component and an error device.

Preferably, the RF component comprises an analogue RF power amplifier and the error device comprises an RF error amplifier.

Preferably, the circuit further comprises a feedback loop to feed the RF output signal back to the adaptation circuit.

Preferably, the adaptation circuit comprises an estimator and buffers for processing the feedback signals in batches.

In accordance with a third aspect of the present invention, a communication system basestation comprises a digital signal generator to generate a baseband digital input signal; a linearised power amplifier circuit according to the second aspect; and a transmitter to transmit the RF output signal.

In accordance with a fourth aspect of the present invention, a method of linearising an RF power amplifier comprises receiving a digital input signal at a baseband stage; delay matching the input signal with an error signal; converting the input signal to an RF input signal; converting the error signal to an RF error signal; applying the RF input signal to an RF power amplifier; applying the RF error signal to an RF error amplifier; combining the amplified RF error signal with the amplified RF input signal to generate an RF output signal; outputting the RF output signal; and feeding back the RF output signal to the baseband stage.

Preferably, the error signal is generated by a digital representation of the RF power amplifier.

Preferably, the digital representation of the RF power amplifier is determined by a generalised memory polynomial representation with a least squares feedback technique used to estimate the optimum coefficients.

Preferably, an output signal from the generalised memory polynomial model comprises three terms: an input signal at selected delays multiplied by an envelope of the input signal raised to selected powers at the same delay; the input signal at selected delays multiplied by the envelope of the input signal, raised to selected powers and at an earlier time offset to the selected delays; and the input signal at selected delays multiplied by the envelope of the input signal, raised to selected powers and at a later time offset to the selected delays.

Preferably, the coefficients controlling the proportion of each of these terms are adaptively computed to obtain the best least squares match of the output signal from the model to the output signal from the real PA

Preferably, the error signal is adapted in response to the RF output signal.

Preferably, the input signal and error signal are converted by inputting each signal to a digital to analogue converter to obtain intermediate frequency signals and up-converting the IF error signal and IF input signal to RF error signal and RF input signal.

Preferably, the delay matching of the input signal with the error signal is carried out by applying a time delay to the digital input signal.

Preferably, equalisation is applied to the digital input signal to compensate for variation in frequency response of the RF power amplifier over its frequency of operation.

With the use of a suitable update method, adaptation may be carried out on a sample by sample basis, but preferably, the adaptation of the error signal is carried out by batch processing.

In accordance with a fifth aspect of the present invention, a method of linearising a device comprises receiving a digital input signal at a first stage; synchronising the input signal with an error signal; converting the digital input signal to an analogue input signal; converting the digital error signal to an analogue error signal; applying the analogue input signal to the device in the second stage; applying the analogue error signal to an error amplifier in the second stage; combining an amplified error signal with an amplified input signal to generate a device output signal; outputting the device output signal; and feeding back the corrected output signal to the first stage.

In accordance with a sixth aspect of the present invention, a linearised device circuit comprises an input to a first stage, the first stage comprising a delay matching circuit; and a digital model of a device to be linearised; the circuit further comprising a main signal digital to analogue converter; an error signal digital to analogue converter; a device to be linearised; an error amplifier; and a feedback from a combined output of the device and the error amplifier to the first stage.

The device may be an RF power amplifier, such as a class D type amplifier.

An example of the present invention will now be described with reference to the accompanying drawings in which:

Figure 1 illustrates conventional digital predistortion;

Figure 2 is a block diagram illustrating conventional feedforward;

Figure 3 illustrates a combination of conventional feedforward and predistortion;

Figure 4 is a simplified block diagram illustrating a linearisation device and method according to the present invention;

Figure 5 illustrates the linearisation device and method of the present invention in more detail;

Figure 6 shows an example of a spectrum for a compensated power amplifier response according to the present invention; and,

Figure 7 illustrates in more detail how a digital representation is determined, of a component to be linearised in accordance with the method of the present invention.

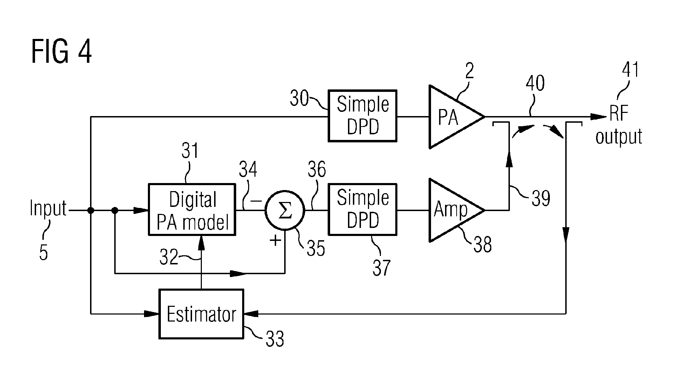

The present invention provides a technique which is based on a modified version of the feedforward principle. At its simplest, the invention provides a baseband error circuit in which a digital signal is input to a digital model of a component to be linearised, such as an RF power amplifier, and in parallel, the same signal is delayed. The output of the digital model and the delayed digital signal are combined in a summer to generate an error signal. This error signal can then be used to correct the output of the real RF component. An example of this is shown in the block diagram of Fig.4, illustrating how the feedforward error signal is generated using an adaptive digital model of the power amplifier, rather than the amplifier itself. Fig. 4 shows the input signal 5 passes though a simple digital pre-distorter 30 placed before the PA 2 in the circuit. In parallel, the input signal 5 passes though a digital PA model 31 which receives an adaption input 32 from an estimator 33. An output 34 of the model 31 is combined in a summer 35 with the input signal 5 to produce an error signal 36. The error signal passes through a simple digital pre-distorter 37 and a wideband low power error amplifier 38, then the amplified error signal 39 is combined with the PA output 40. The combined RF output 41 is fed back to the estimator 33 and used to update the adaption input 32 to the digital PA model.

The invention still generates an error signal, but instead of subtracting the output from the input, a digital model is used to generate a digital output which goes into the error amplifier. The digital error circuit synthesises an erroneous output produced by the real PA and then inverts it to produce a signal to correct the errors at the output of the real PA As the model is digital, a digital delay can be put in to align the paths. In order that the models are as close as possible to the real amplifier, use of the adaptation circuit enables the model to be adaptive. Also the feedback is from the very final point of the output, so takes into account any errors caused by the operation of the error amplifier itself. A simple digital predistorter, generally a fixed, rather than adaptive one, can be used to improve the error amplifier, which can be made more efficient due to linearising at its input.

This approach enables the error signal to be generated synchronously with the main amplifier output, thus avoiding the need for the high power (lossy) delay line handling signals, of the order of several hundred watts, at the output, improving the overall efficiency. A further benefit of the technique is that since the error signal is generated digitally, it is possible to apply digital predistortion to both the main and error paths, enabling a further reduction in the power of the error amplifier, giving an additional efficiency improvement.

As with predistortion, the PA model may be dynamically adapted to try and minimise the overall output-minus-input error residue. However, unlike predistortion, the model attempts to replicate the characteristics of the physical PA, rather than to generate an inverse non-linear function.

Conventional digital predistortion uses a generalised memory polynomial (GMP) to predict the output of the PA, given samples of the input signal that are aligned in time and both leading and lagging in time. The Pth order inverse of this model is then computed to give the required digital predistortion function. One alternative to computing the Pth order inverse is to model an inverse amplifier. This approach relies on postdistorting the PA output using the inverse PA model, then using the difference between the postdistorted output and the PA input to create an error signal to adapt the inverse PA model. The same inverse PA model is also applied before the input to the PA to predistort the signal to be amplified. The creation of an inverse matrix can cause problems in the estimator stage, since this is not mathematically stable.

The approach of the present invention uses a single instance of the PA model. This avoids any requirement to compute the Pth inverse (a computationally expensive task). Since the error signal is used to adapt a model of the PA directly (rather than an inverse model) the equations are numerically better conditioned and a more accurate model results. In addition since only one instance of the PA model is required (rather than 2 instances of an inverse model) there is less scope for propagation of numerical inaccuracies. Furthermore the feedback error signal, used in the estimator for adapting the model in conjunction with the output feedback signal, is formed directly from the input signal, rather than a signal that has already been through a predistortion stage. Thus accuracy is further improved.

The digital processing advantages of the approach of the present invention include the fact that no inverse PA model computation is required; the error signal adapts a model of the PA, not the inverse PA, and hence is numerically more stable and accurate; only one instance of the PA model is required for the processing; and the error signal is computed directly from the input signal rather than a signal that has already been through the predistortion processing, hence better numerical performance is possible.

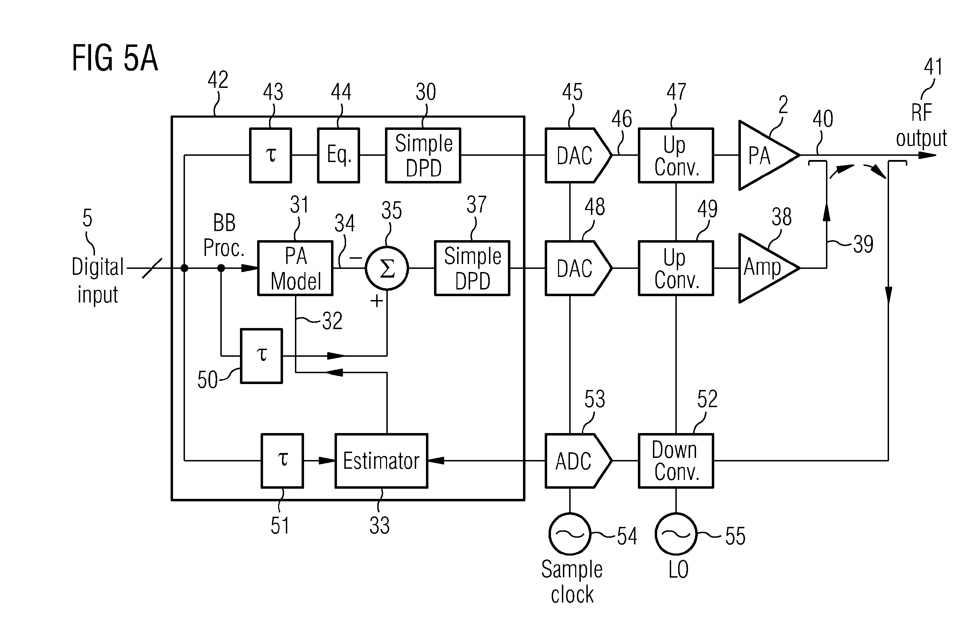

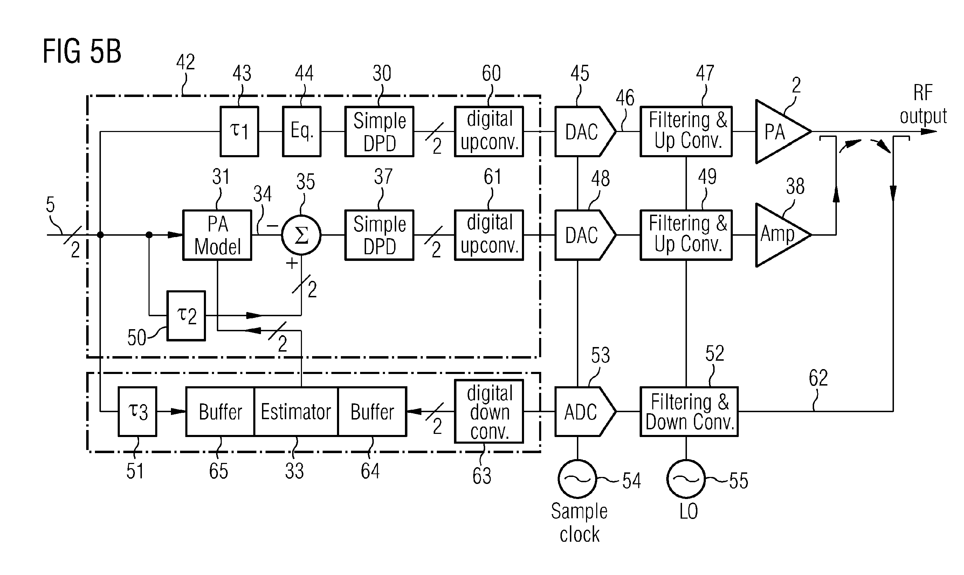

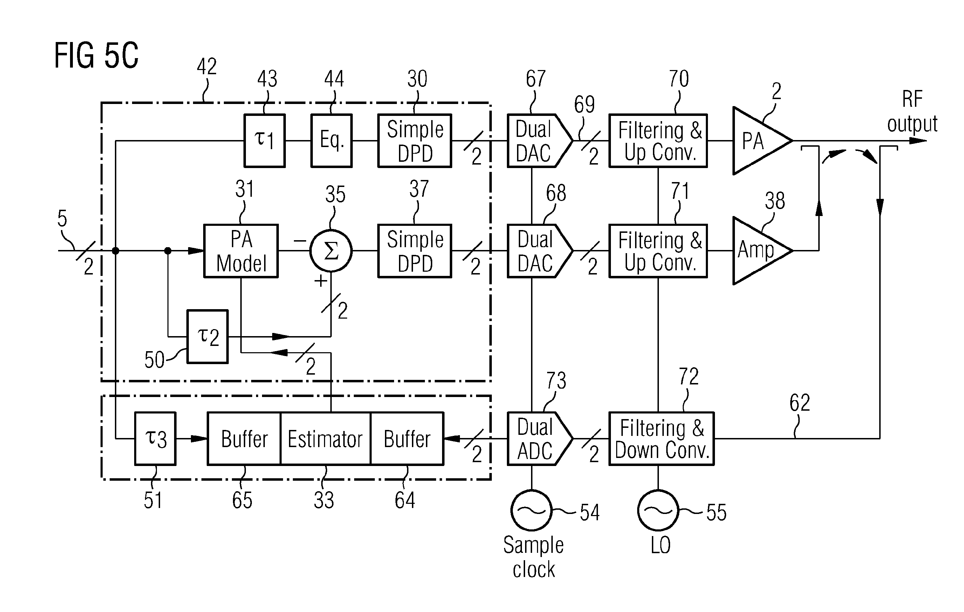

A more detailed block diagram of the technique of the present invention is shown in Fig.5. In Fig. 5, the digital signal 5 is input to a first baseband processing stage 42, comprising an adjustable power amplifier model and a delay matching circuit. In the delay matching circuit, the digital input signal 5 passes through a time delay 43, equaliser 44 and the simple digital pre-distorter 30 to a digital to analogue converter 45, the output 46 of which is at an intermediate frequency (IF). The IF signal is upconverted in upconverter 47 and input to the power amplifier 2. Typical values for the IF stage are from 10s of MHz to low 100s of MHz.

In the adjustable model, the digital input 5 passes though the power amplifier model 31 to the summer 35 and simple digital pre-distorter 37, then via a DAC 48 to the IF stage. The input signal is upconverted 49 and amplified in a wideband lower power error amplifier 38 before the amplified error signal 39 is reinserted into the PA output 40. Since the frequency response of the power amplifier 2 varies in amplitude and phase over the band, there is a fixed correction provided by the equaliser 44. Without this the error signal would be larger. Thus, a smaller error amplifier 38 can be used which is cheaper and uses less power. The reduction could be as great as 100 to 1 compared to the power amplifier power.

The input signal passes through a time delay 50 and is combined with the PA model output 34 in the summer 35 and also passes through a time delay 51 to the estimator 33 to provide the adaptation signal 32 to the PA model 31, after being combined in the estimator 33 with the RF output 41 fed back via a down-converter 52 and an ADC 53. The RF signal for GSM is around 900 MHz and for 3G, in the region of 2.1 GHz. A sample clock 54 is provided for the DACs 45, 48 and ADC 53 and a local oscillator 55 for the upconverters 47, 49 and down-converter 52. The local oscillator frequency is the difference between the RF and IF, so comparable with the output frequency.

The digital input to the lineariser generally comprises a series of digitised samples that represent one or more modulated carriers to be amplified. These can take one of two forms, either complex baseband, in which samples are provided that relate to in-phase components and to quadrature components, or with some added offset frequency such that the frequency spectral components of all modulated carriers are positive. In this latter case the signal can be represented by a stream of digitised real samples.

Where more than one carrier is linearised, the definition of complex baseband or of the IF frequency where one is present is potentially ambiguous, particularly where more than one modulation type is present. For example, suppose the multiple carriers consist of one wideband CDMA carrier at the lowest frequency, with GSM carriers separated from it at higher frequencies. The centre frequency of the set of carriers is not unambiguously defined. For example it could be defined as the centre frequency between the lowest and highest carrier frequencies or between the lowest frequency spectral component of the lowest frequency signal or the highest frequency spectral component of the highest frequency signal. In the above example these would not be the same. Provided the sample rate is high enough it is not imperative that the centre frequency be unambiguously defined.

The digital output of the lineariser is converted to analogue to generate a compensation signal to be applied to the output of the power amplifier for linearisation. In the same way as for the digital input, this may be represented either as complex baseband or at an intermediate frequency. In order to obtain the desired output frequency it may be necessary, digitally to offset the output frequency applied to the DAC from the output of the linearisation device. This can be done using a numerically controlled oscillator and complex multiplier as is well known to those versed in the art.

There are a range of issues surrounding the preferred choice of IF frequency for the output of the linearisation circuit. The advantage of using zero IF is the use of the minimum possible sample rate and general simplicity in the RF circuitry. The disadvantages include the need for twin DACs to handle the in-phase and quadrature components. Additionally the signal spectral quality is adversely affected by a combination of phase and amplitude missmatching in the analogue paths and missmatching between the analogue reconstruction filters following the DACs and DC offsets in the mixers that upconvert the signals to RF, leading to carrier insertion. All but the DC offsets can be compensated by feedback loops.

Given the difficulties involved with direct RF upconversion of the compensation signal it may be preferable to upconvert from a non-zero IF. This requires only one DAC, but this one DAC needs to be able to operate at a high frequency. It is not necessary to have a sample rate that is Nyquist with respect to the IF plus the highest baseband frequency if subsampling is applied. In this case, a suitable IF filter is required with the ability to adequately reject the subsampling aliases and act as a reconstruction filter. After conversion to an analogue IF, the signal requires analogue RF upconversion to the final frequency. This process generates an unwanted image frequency that needs to be removed by filtering. Further attenuation can be achieved through the use of an image cancelling filter, as well known to those versed in the art. Depending on the bandwidth of the signal to be transmitted and the practical choice of digital IF it may be necessary to use two analogue RF upconversion stages to achieve the desired image rejection with practical, cost effective RF filters.

The specific implementation of the circuit of Fig.5a varies according to whether a low IF approach is used, or complex baseband and zero IF. Low IF is preferred due to problems with IQ mismatch in the zero IF implementation. Examples of these are illustrated in Figs. 5b and 5c respectively. In both examples, processing of the multicarrier digital signals in the delay matching and error circuits is by sample based field programmable gate array processing and in the adaptation circuit, batch processing is used, although by using a different update method, a sample by sample basis may be used for the adaptation circuit.

In Fig. 5b, baseband processing is done at complex baseband to minimise the sample rates. The baseband signals to be output are interpolated and digitally upconverted 60, 61 to a low IF frequency, before then converting 45 to analogue. In a similar way a feedback signal 62 is filtered and downconverted 66 to a low IF, digitised 53 at low IF, then digitally down converted 63 to complex baseband and the sample rate reduced by decimation. The estimator 33 is provided with buffers 64, 65 for the digital down converted feedback signal and the time delayed 51 input, so that the adaptation can run by batch processing in a digital signal processor.

For the zero IF approach, shown in Fig. 5c, dual DACs 67, 68 are provided for the outputs of the DPDs 30, 37 of the delay matching and error circuits and the outputs of the DACs at zero IF 69 are filtered and upconverted 70, 71. The feedback signal 62 is filtered and downconverted 72 to zero IF and converted to digital in a dual ADC 73.

In order to investigate the effectiveness of the digital feedforward concept, a simulation of the technique was carried out, which involved two simulation activities. In step 1, non linear PA modelling was done. An RF circuit simulator was used to construct and accurately simulate all of the nonlinear behaviour and memory effects exhibited by a real PA. This tool contains non-linear models of the physical RF power devices and their associated packaging, biasing and matching components. The output stage simulated used an LDMOS device capable of 170W peak envelope power (PEP) at 2.1GHz. This simulation was used to generate files of sampled data for the input and output of the PA. These were converted to a complex baseband equivalent and decimated to a suitable sample rate.

In step 2, digital feedforward (DFF) linearization modelling was carried out. A Matlab simulation was constructed to model the digital processing elements of the system. The Matlab simulation reads in the complex baseband sampled data for the PA input and PA output from files generated using the MWO simulation. A digital model of the PA is computed using the GMP as outlined above. The coefficients of this digital model are adapted, so that the behaviour of the digital model follows the MWO PA as accurately as possible. Using the output of the GMP, a compensation signal is generated and added to the MWO PA output samples. The power spectrum of this signal is computed and compared against the uncompensated MWO PA output.

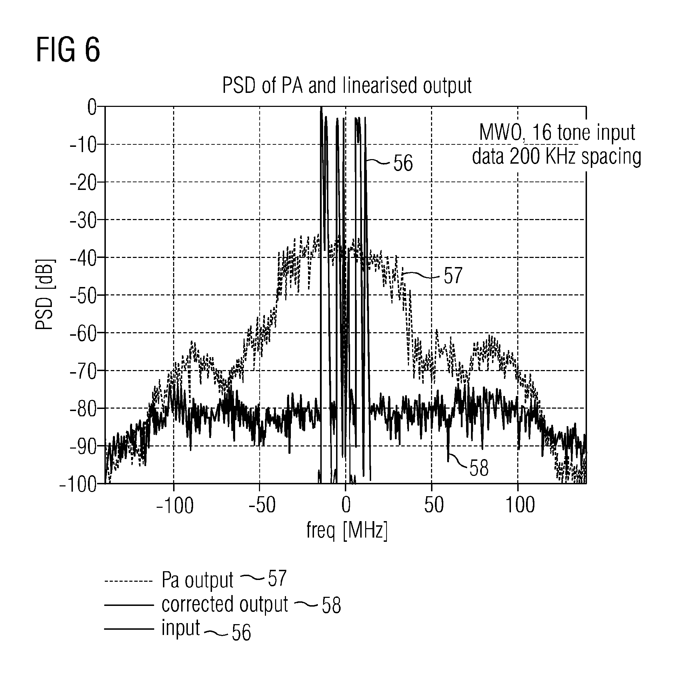

An example output spectrum of power spectral density in dB against frequency in MHz from the Matlab simulation is shown in Fig.6, using an 8 tone test signal occupying approximately 25MHz of bandwidth with 200 KHz spacing. The higher trace 56 centred about zero shows the PA input signal, the middle trace 57 shows the PA output before linearization, and the lower trace 58 shows the corrected PA output after the digital feedforward linearization has been applied. It may be seen that the technique is highly effective, and it is able to reduce the level of the intermodulation products down to around -80dBc.

The test signal 56 is in this example made up of eight tones. The output signal 57 shows what comes from the power amplifier without corrections, indicating how sidelobes are formed as well as the overlaid wanted signals. The sidebands block other channels, since they are not sufficiently small relative to the wanted signal. This has the effect of reducing available capacity for transmission. The corrected signal trace 58 shows the effect of applying the present invention. Although there are sidelobes, their level is such that they do not interfere significantly. The illustration is for a narrowband signal such as GSM, but the invention is equally applicable to wideband signals, such as 3G and LTE.

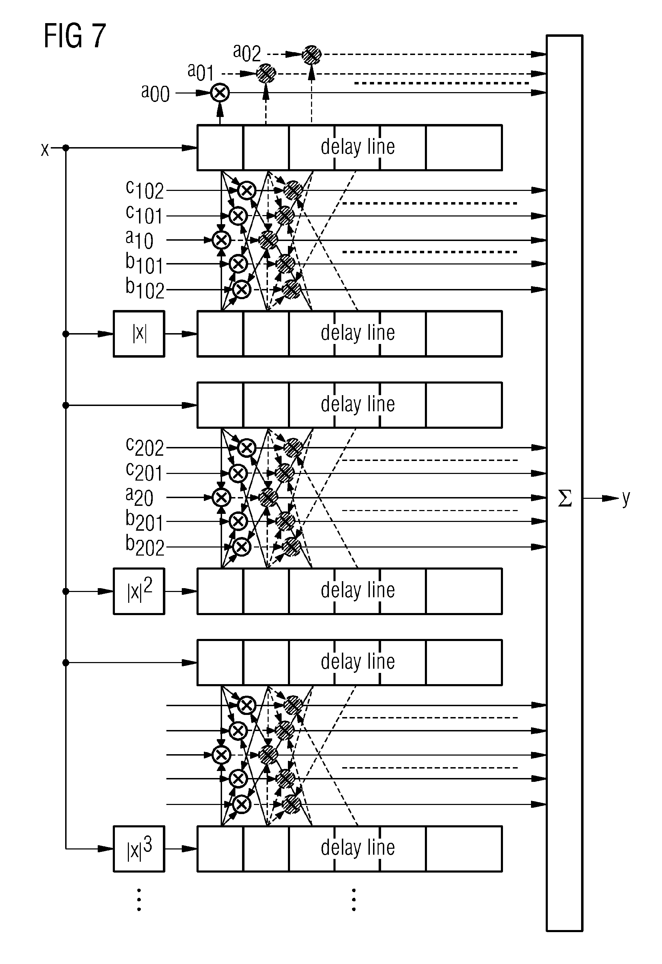

The digital representation of the RF power amplifier is determined by a generalised memory polynomial representation with a least squares feedback technique used to estimate the optimum coefficients. This is illustrated in Fig.7.

The output signal $[\hat{y}(n)]$ from the generalised memory polynomial model comprises three terms: the input signal at selected delays $[x(n-l)]$ multiplied by the envelope of the input signal (at the same delay) raised to selected powers $[|x(n-l)|^k]$; the input signal at selected delays multiplied by the envelope of the input signal at an earlier time offset (to the selected delays) raised to selected powers $[|x(n-l-m)|^k]$; and the input signal at selected delays multiplied by the envelop of the input signal at a later time offset (to the selected delays) raised to selected powers $[|x(n-l+m)|^k]$;. The coefficients $[a, b, c]$ that control the proportion of each of these terms are adaptively computed to obtain the best match (in a least squares sense) of the output signal from the model to the output signal from the real PA.

This can be described mathematically, where $\hat{y}(n)$ is the output of the GMP model and $x(n)$ is the input at sample time n and the coefficients $a_{kl}, b_{klm}$ and $c_{klm}$ are adaptively chosen.

$$\widehat{y}(n) = \sum_{k \in \mathcal{K}_a} \sum_{l \in \mathcal{L}_a} a_{kl} x(n-l) \left| x(n-l) \right|^k$$

$$+ \sum_{k \in \mathcal{K}_b} \sum_{l \in \mathcal{L}_b} \sum_{m \in \mathcal{M}_b} b_{klm} x(n-l) \left| x(n-l-m) \right|^k$$

$$+ \sum_{k \in \mathcal{K}_c} \sum_{l \in \mathcal{L}_c} \sum_{m \in \mathcal{M}_c} c_{klm} x(n-l) \left| x(n-l+m) \right|^k$$

$\widehat{y}(n)$ is determined using valid $k$ indices from a set of integers e.g. $K_a$ and valid 1 indices from a set of integers e.g. $L_a$ to give the number of coefficients. Thus, if $k$ is chosen to be from the set of all integers from 0 to 5 and $l$ is chosen to be from the set of all integers from 0 to 2, then there are 18 coefficients for $a_{kl}$.

The range of the indices $k$, $l$, m are chosen in advance by specifying the sets of integers $K_a$, $L_a$, $K_b$, $L_b$, $M_b$, $K_c$, $L_c$, $M_c$, depending upon the characteristics of power amplifier being modelled (e.g. $K_a$ = {0,1,2,3,4,5} $K_b$ = {2,4}). This defines the number of coefficients in the model. The values of the coefficients $a$, $b$ and $c$ are adaptively modified to take account of differences between the real output and the modelled output.

Other applications with current technology include digital audio broadcast or any other transmitter needing good linearity, generally high power amplifiers. As digital processing improves, the invention may have application at lower transmit power and for greater bandwidths.

**Claims**

1. A linearisation device, the device comprising a device input and a digital baseband stage; the digital baseband stage comprising an error circuit, wherein the error circuit comprises a digital representation of a component to be linearised; a digital delay, a summer and an error circuit output; wherein a signal received at the device input is input to the digital representation and the time delay; wherein respective outputs of the digital representation and the time delay are subtracted in the summer to generate an error signal; and wherein the error signal is output from the error circuit output.

2. A device according to claim 1, wherein the baseband stage further comprises a delay matching circuit; and a delay matching circuit output.

3. A linearisation device according to claim 2, wherein the delay matching circuit and the digital representation of the component are implemented in a field programmable gate array.

4. A linearisation device according to claim 2 or claim 3, wherein the delay matching circuit and the digital representation further comprise digital predistorters.

5. A linearisation device according to any of claims 2 to 4, wherein the delay matching circuit further comprises an equaliser to correct for variation in the frequency response of the component across the signal frequency band.

6. A device according to any preceding claim, wherein the baseband stage further comprises a digital adaptation circuit.

7. A linearisation device according to claim 6, wherein the adaptation circuit comprises a digital signal processor.

8. A linearisation device according to any preceding claim, wherein the component is an analogue component.

9. A linearisation device according to any preceding claim, wherein the component is an RF amplifier.

10. A linearised power amplifier circuit, the circuit comprising a device according to any of claims 1 to 9; an intermediate frequency stage; and a radio frequency stage.

11. A circuit according to claim 10, wherein the IF stage comprises signal converters to convert between digital and analogue signals and frequency converters to convert between IF and RF signals.

12. A circuit according to claim 10 or claim 11, wherein the RF stage comprises the RF component and an error device.

13. A circuit according to claim 12, wherein the RF component comprises an analogue RF power amplifier and the error device comprises an RF error amplifier.

14. A circuit according to any of claims 10 to 13, wherein the circuit further comprises a feedback loop to feed the RF output signal back to the adaptation circuit.

15. A circuit according to claim 14, wherein the adaptation circuit comprises an estimator and buffers for processing the feedback signals in batches.

16. A communication system basestation, the basestation comprising a digital signal generator to generate a baseband digital input signal; a linearised power amplifier circuit according to any of claims 10 to 15; and a transmitter to transmit the RF output signal.

17. A method of linearising an RF power amplifier, the method comprising receiving a digital input signal at a baseband stage; delay matching the input signal with an error signal; converting the input signal to an RF input signal; converting the error signal to an RF error signal; applying the RF input signal to an RF power amplifier; applying the RF error signal to an RF error amplifier; combining the amplified RF error signal with the amplified RF input signal to generate an RF output signal; outputting the RF output signal; and feeding back the RF output signal to the baseband stage.

18. A method according to claim 17, wherein the error signal is generated by a digital representation of the RF power amplifier.

19. A method according to claim 17 or 18, wherein the digital representation of the RF power amplifier is determined by a generalised memory polynomial representation with a least squares feedback technique used to estimate the optimum coefficients.

20. A method according to claim 19, wherein an output signal from the generalised memory polynomial model comprises three terms: an input signal at selected delays multiplied by an envelope of the input signal raised to selected powers at the same delay; the input signal at selected delays multiplied by the envelope of the input signal, raised to selected powers and at an earlier time offset to the selected delays; and the input signal at selected delays multiplied by the envelope of the input signal, raised to selected powers and at a later time offset to the selected delays.

21. A method according to claims 19 or 20, wherein the coefficients controlling the proportion of each of these terms are adaptively computed to obtain the best least squares match of the output signal from the model to the output signal from the real PA

22. A method according to any of claims 17 to 21, wherein the error signal is adapted in response to the RF output signal.

23. A method according to any of claims 17 to 22, wherein the input signal and error signal are converted by inputting each signal to a digital to analogue converter to obtain intermediate frequency signals and up-converting the IF error signal and IF input signal to RF error signal and RF input signal.

24. A method according to any of claims 17 to 23, wherein the delay matching of the input signal with the error signal is carried out by applying a time delay to the digital input signal.

25. A method according to any of claims 17 to 24, wherein equalisation is applied to the digital input signal to compensate for variation in frequency response of the RF power amplifier over its frequency of operation.

26. A method according to any of claims 17 to 25, wherein the adaptation of the error signal is carried out by batch processing.

27. A method of linearising a device, the method comprising receiving a digital input signal at a first stage; synchronising the input signal with an error signal; converting the digital input signal to an analogue input signal; converting the digital error signal to an analogue error signal; applying the analogue input signal to the device in the second stage; applying the analogue error signal to an error amplifier in the second stage; combining an amplified error signal with an amplified input signal to generate a device output signal; outputting the device output signal; and feeding back the corrected output signal to the first stage.

28. A linearised device circuit, the circuit comprising an input to a first stage, the first stage comprising a delay matching circuit; and a digital model of a device to be linearised; the circuit further comprising a main signal digital to analogue converter; an error signal digital to analogue converter; a device to be linearised; an error amplifier; and a feedback from a combined output of the device and the error amplifier to the first stage.

29. A circuit according to claim 28, wherein the device is an amplifier.

30. A circuit according to claim 29, wherein the amplifier is a power amplifier.

31. A circuit according to claim 30, wherein the power amplifier is an RF power amplifier.

32. A circuit according to claim 31, wherein the RF power amplifier is a class D type amplifier.

## FIG 1

## FIG 2

## FIG 3

FIG 4

FIG 5A

EP 2 159 914 A1

# FIG 5B

EP 2 159 914 A1

FIG 5C

FIG 6

PSD of PA and linearised output

MWO, 16 tone input
data 200 KHz spacing

........ Pa output ⌐57
———— corrected output ⌐58
———— input ⌐56

FIG 7

Europäisches
Patentamt

European
Patent Office

Office européen
des brevets

# EUROPEAN SEARCH REPORT

Application Number

EP 08 27 5046

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/001559 A1 (PINCKLEY DANNY THOMAS [US] ET AL) 1 January 2004 (2004-01-01)<br><br>* paragraph [0023]; figure 4 *<br>* paragraph [0052] - paragraph [0057] *<br>----- | 1-4, 6-18, 22-26 | INV.<br>H03F1/32 |
| X | US 5 959 500 A (GARRIDO ARMANDO COVA [CA]) 28 September 1999 (1999-09-28)<br><br>* column 5, line 55 - column 9, line 67; figure 3 *<br>----- | 1-3, 6-18, 22-26 | |
| X | US 6 188 732 B1 (RHA PETER S [US]) 13 February 2001 (2001-02-13)<br><br>* column 7, line 59 - column 9, line 67; figure 5 *<br>----- | 1-3, 6-14,16, 22-26 | |
| A | CA 2 359 996 A1 (TELECOMM RES LAB [CA]) 3 May 2002 (2002-05-03)<br>* paragraph [0023]; figure 1 *<br>----- | 1 | TECHNICAL FIELDS SEARCHED (IPC)<br><br>H03F |

The present search report has been drawn up for all claims

| Place of search | Date of completion of the search | Examiner |
|---|---|---|
| Munich | 23 February 2009 | Kurzbauer, Werner |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

Application Number

EP 08 27 5046

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

see annex

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 08 27 5046

The Search Division considers that the present European patent application does not comply with the
requirements of unity of invention and relates to several inventions or groups of inventions, namely:

1. claims: 1-18,22-26 (insofar as they refer to claims 17 and 18)

    A linearisation device comprising an error circuit
    comprising a digital representation of a component to be
    linearised, a delay circuit and summer in order to provide
    an error signal which is output from the error circuit and -
    after conversion - combined with the RF output signal and
    the corresponding method.
           ---

2. claims: 19-21

    A method to realise the digital representation of the RF
    amplifier using a polynomial representation with least
    squares feedback technique.
           ---

3. claims: 27-32

    A linearised device circuit comprising a delay matching
    circuit, a digital model of a device to be linearised,
    digital to analog converters and a feedback from a combined
    output of the device to be linearised and the error
    amplifier to the first stage and the corresponding method.
           ---

**ANNEX TO THE EUROPEAN SEARCH REPORT
ON EUROPEAN PATENT APPLICATION NO.**

EP 08 27 5046

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2009

| Patent document cited in search report | | Publication date | Patent family member(s) | Publication date |
|---|---|---|---|---|
| US 2004001559 | A1 | 01-01-2004 | NONE | |
| US 5959500 | A | 28-09-1999 | NONE | |
| US 6188732 | B1 | 13-02-2001 | KR   20000035043 A | 26-06-2000 |
| CA 2359996 | A1 | 03-05-2002 | NONE | |

For more details about this annex : see Official Journal of the European Patent Office, No. 12/82